**Europäisches Patentamt**

**European Patent Office**

**Office européen des brevets**

(11) Numéro de publication: **0 195 871**
**A1**

## DEMANDE DE BREVET EUROPEEN

(21) Numéro de dépôt: **85400623.6**

(22) Date de dépôt: **29.03.85**

(51) Int. Cl.⁴: **H 01 R 23/66,** H 01 R 43/24, H 01 B 7/08

(43) Date de publication de la demande: **01.10.86 Bulletin 86/40**

(71) Demandeur: **Nozick, Jacques E., C.T.M. 28 rue Broca, F-75005 Paris (FR)**

(72) Inventeur: **Nozick, Jacques E., C.T.M. 28 rue Broca, F-75005 Paris (FR)**

(84) Etats contractants désignés: **AT BE CH DE GB IT LI LU NL SE**

(74) Mandataire: **Pinguet, André, CAPRI 28 bis, avenue Mozart, F-75016 Paris (FR)**

(54) Connecteur électrique multipolaire et son procédé de fabrication.

(57) On fabrique des connecteurs en appliquant la méthode utilisée pour les câbles plats. Une nappe de conducteurs (1a–1d) est recouverte sur les deux faces par des feuilles isolantes que l'on fait adhérer l'une à l'autre et aux conducteurs. Des lacunes sont réservées dans les feuilles pour laisser à nu des segments de conducteurs. Après découpage et formage, on obtient des connecteurs qui peuvent revêtir une variété de formes pour une variété d'applications.

- 1 -

Connecteur électrique multipolaire et son procédé de fabrication.

La présente invention a pour objet un procédé de fabrication de connecteur électrique multipolaire ainsi que les connecteurs obtenus par ce procédé.

L'invention a notamment pour but de réaliser un connecteur multipolaire de prix de revient relativement bas, par application d'un procédé original.

Conformément à la présente invention, le procédé de fabrication d'un connecteur multipolaire comporte les étapes suivantes :
- on dispose parallèlement en une nappe plane, un certain nombre de conducteurs en matériau à mémoire élastique ;
- on applique sur la nappe au moins une feuille de matière isolante, de façon à maintenir les conducteurs relativement les uns par rapport aux autres ;
- on découpe le connecteur dans la nappe recouverte ; et,
- on effectue des pliages appropriés du connecteur.

Selon un mode d'application préféré de l'invention, on applique une feuille de matière isolante de chaque côté de la nappe de conducteurs. Avec des feuilles thermosoudables, une application avec chaleur et pression fournit un ensemble homogène. Cependant, on pourrait dans certains cas n'utiliser qu'une feuille qui adhérerait aux conducteurs ou qui les enroberait alors que la matière de la feuille est ramollie.

Selon un mode d'application avantageux de l'invention, au moins une des feuilles de matière isolante comporte des ouvertures.

L'invention vise également les connecteurs ainsi obtenus.

Il est connu de tenir en sandwich entre des feuilles isolantes des pluralités de conducteurs en cuivre par exemple, plats ou ronds, de manière à réaliser des câbles plats. Il est aussi connu de dénuder une partie des câbles pour réaliser un fichier de connexions. On sait aussi réaliser des fichiers de connexions en utilisant des feuilles isolantes comportant des ouvertures, en regard ou non. Le fichier de connexions n'a qu'un rôle de surface de contact. Or, pour réaliser un contact électrique, il faut avoir simultanément deux surfaces de contact en présence et une pression mettant en appui l'une sur l'autre les deux surfaces.

Il est aussi connu d'utiliser des contacts en bande découpés au même pas que celui du connecteur dans lequel ils doivent être insérés. Le grand avantage de cette technique est d'insérer un grand nombre de contacts simultanément avec des outils relativement simples. Il reste cependant un problème important à résoudre qui consiste à détacher les contacts des rives porteuses pour les rendre électriquement indépendantes, ce qui implique une opération de séparation et un transfert dans un drageoir avant l'insertion des contacts devenus indépendants.

Il est aussi connu de surmouler des pluralités de contacts dans un isolant. C'est une technique relativement longue et coûteuse nécessitant un moule et un guidage préalable des contacts.

Aucun de ces dispositifs ne peut offrir un contact multipolaire de qualité pour un prix de revient comparable à celui de la présente invention.

D'autres caractéristiques de l'invention apparaîtront au cours de la description qui va suivre, donnée à titre d'exemple non limitatif en regard des dessins ci-joints, et qui fera bien comprendre comment l'invention peut être réalisée.

Sur les dessins :
- la figure 1 est une vue en perspective schématique illustrant le procédé de la présente invention pour fabriquer un exemple de connecteur ;
- la figure 2 est une vue en plan représentant un produit intermédiaire du procédé de l'invention ;
- la figure 3 est une vue en perspective d'un exemple de connecteur selon l'invention, obtenu par le procédé illustré sur les figures 1 et 2 ;
- la figure 3A est une vue partielle d'une variante de connecteur ;
- la figure 4 est une vue en coupe représentant un autre exemple de connecteur selon l'invention, utilisable pour connecter ensemble deux circuits imprimés indépendants ;
- la figure 5 est une vue en coupe d'un exemple de connecteur soudable pour circuit imprimé ;
- la figure 6 est une vue en coupe suivant la ligne VI-VI de la figure 5 ;
- la figure 7 est une vue en élévation, de côté, d'une limande encartable irréversible réalisée par le procédé de l'invention ;
- la figure 8 est une vue analogue d'une limande réversible ;
- la figure 9a est une vue en coupe d'un support de composant pour circuit imprimé, réalisé par le procédé de l'invention ;
- les figures 9b, 9c, 9d représentent des variantes de

- 4 -

0195871

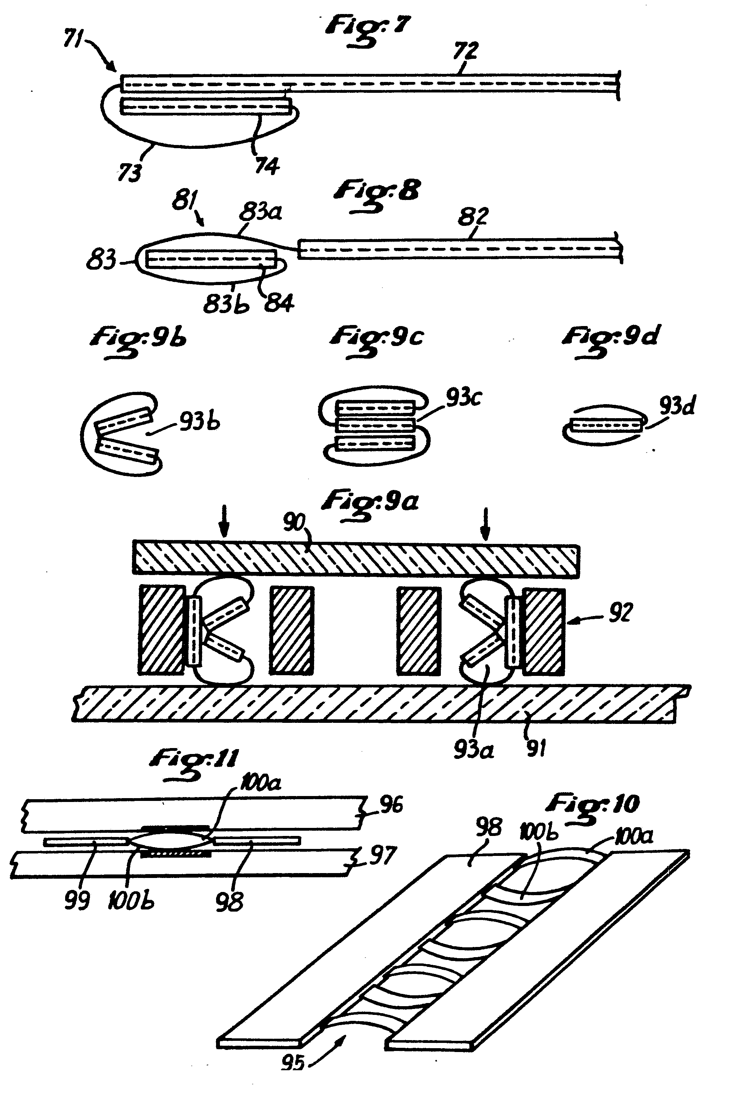

contacts pour le support de la figure 9a ;
- la figure 10 est une vue en perspective d'un connecteur de liaison entre deux circuits imprimés ; et,
- la figure 11 représente le connecteur en place.

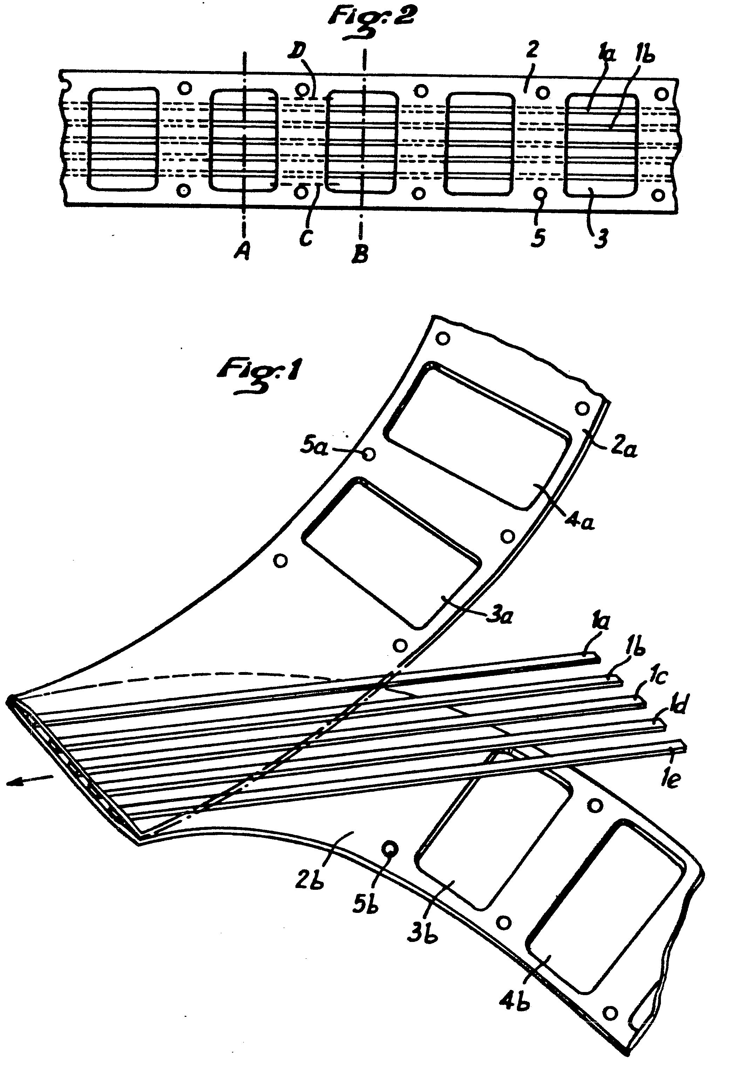

La figure 1 illustre schématiquement un mode de mise en oeuvre du procédé de la présente invention. On forme une nappe de fils conducteurs 1a - 1e, cinq dans cet exemple. Le nombre n'est pas limitatif, les fils peuvent être identiques ou non, plats ou ronds ou autre, écartés régulièrement ou non, selon l'usage prévu pour le connecteur. En vue d'avoir la pression élastique de contact, on choisira des conducteurs en matériau à mémoire élastique, c'est-à-dire les métaux, revêtus ou non, utilisés habituellement pour les contacts.

Sur les deux faces de la nappe de conducteurs 1, on applique deux feuilles de matériau isolant souple 2a, 2b, et on les rend solidaires l'une de l'autre et, le cas échéant, des conducteurs, par tout moyen approprié. Un moyen avantageux consiste à utiliser des feuilles en matière plastique soudables, par chaleur et pression. Mais, on peut utiliser la soudure par ultrason, la colle ou un autre moyen donnant un résultat équivalent.

On peut procéder en continu, en déroulant régulièrement une nappe de fils 1 à partir de bobines, avec des moyens connus pour les aligner et les maintenir tendus. On tire sur la nappe au moyen d'un tambour d'enroulement et on déroule sur chaque face de la nappe des bandes de matière thermosoudable, qui sont appliquées entre deux rouleaux chauffants par exemple.

0195871

Selon un mode de mise en oeuvre avantageux de la présente invention, les bandes 2a et 2b comportent des ouvertures 3a, 4a...3b, 4b et des trous d'entraînement et de placement 5a, 5b, pour assurer les positions relatives des ouvertures. Les ouvertures peuvent être les mêmes sur les deux bandes, ou peuvent être différentes, en dimension et/ou en position, et les ouvertures consécutives peuvent être différentes ou différemment espacées, selon le type de connecteur que l'on désire réaliser, comme on le verra ci-après.

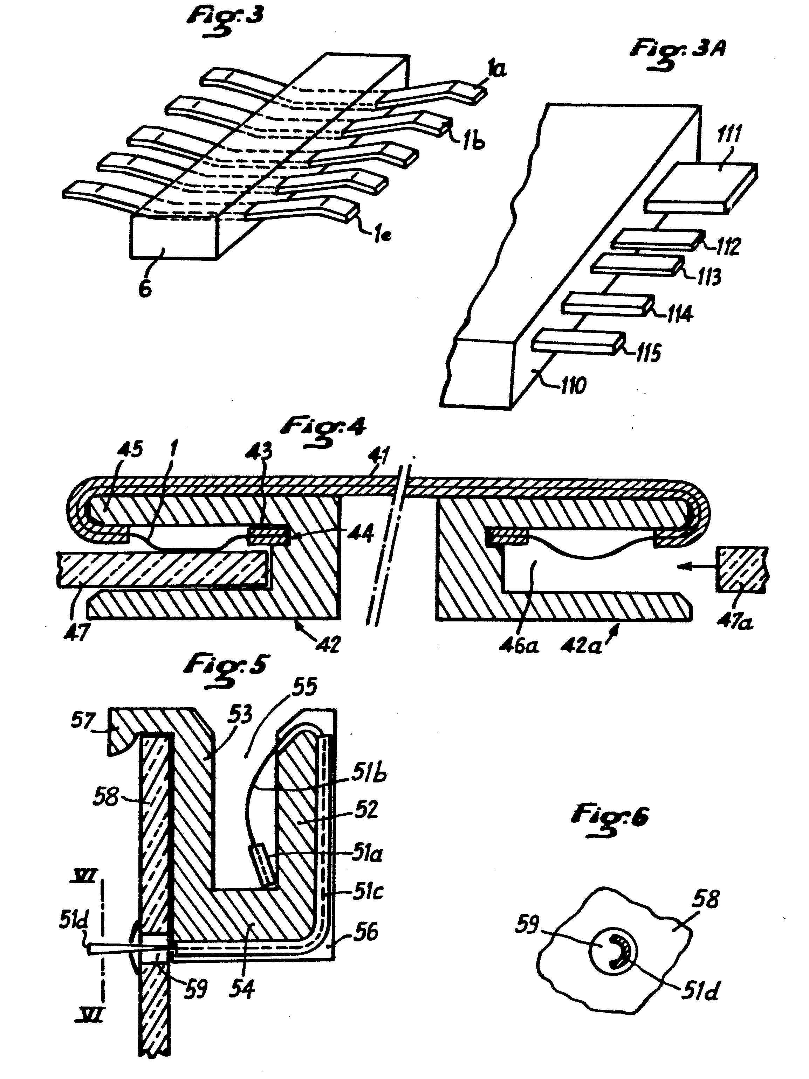

Avec l'exemple représenté sur la figure 1, on obtient une bande continue comme celle dont une certaine longueur est représentée en plan sur la figure 2. Cette bande est formée d'un support 2, avec des fenêtres et des trous d'entraînement 5 et porte des conducteurs 1 qui sont dégagés, au droit des fenêtres, et enrobés et maintenus dans le reste de la bande.

Il serait possible, quoique moins intéressant, d'utiliser des bandes sans fenêtre et de dégarnir ensuite les fils, à la meule par exemple, aux endroits où on le désire.

Pour fabriquer des connecteurs, on découpe la bande convenablement, par exemple à un pas correspondant à celui des ouvertures. Par exemple, on peut couper la bande suivant les lignes transversales A, B et on élimine ensuite les bords inutiles, en coupant suivant les lignes en trait interrompu C, D. On obtient ainsi une ébauche de connecteur. Celui-ci est terminé par des pliages appropriés. Un exemple est représenté en perspective sur la figure 3. On a un corps 6 dans lequel sont enrobées les parties centrales de lames 1. Les pliages des différentes lames peuvent être identiques ou différents selon l'application envisagée. Les conducteurs peuvent être recourbés en long pour former des gouttières.

On comprendra que l'on peut former ainsi des connecteurs de types très variés, comportant un ou plusieurs corps 6, un ou plusieurs faisceaux de lames, le corps et/ou les lames pouvant être pliés une ou plusieurs fois, dans toute direction convenable. A titre d'exemple, on a représenté sur la figure 3A un exemple de nappe de conducteurs, pour connecteur, comportant un contact de puissance 111, deux contacts de signaux 112,113, séparés par un intervalle relativement étroit et deux autres contacts 114, 115 plus épais et plus espacés que les précédents. Les conducteurs sont enrobés dans un isolant 110.

On va décrire ci-après quelques exemples de réalisation pour montrer la variété des connecteurs que l'on peut fabriquer.

La figure 4 représente un câble de connexion souple 41 avec deux connecteurs identiques 42, 42a, aux deux bouts. Les extrémités 43 des câbles sont enrobées pour maintenir ensemble au pas les conducteurs, et sont engagées dans des rainures 44 pour les caler. Sur une partie du câble, voisine de l'extrémité, les conducteurs 1 ne sont pas enrobés, et ensuite le câble est retourné autour d'un bord 45 de la fente 46 du connecteur. Le câble est fixé de toute manière convenable au corps du connecteur 42 (vis, collage ou autre). On peut ainsi introduire une carte 47 dans la fente du connecteur et assurer un contact multiple avec la rangée de contacts formée par les conducteurs 1 dont on aura pris soin de leur faire prendre une forme incurvée, afin d'obtenir

- 7 -

un effet de ressort pour la pression de contact. Le câble peut avoir toute longueur désirée. Dans cet exemple, les conducteurs pourraient être à l'air d'un côté seulement, mais l'effet de ressort sera plus souple si les conducteurs ne sont pas alourdis par une feuille plastique.

La figure 5 représente un autre exemple. Une ébauche comprenant une première extrémité enrobée 51a courte, une partie dégarnie 51b formant rangée de contacts, une partie de liaison relativement plus longue 51c et une deuxième extrémité 51d, est enroulée autour d'une paroi 52 d'un connecteur de bout de carte, comprenant une autre paroi 53 et un fond 54, définissant ensemble une fente de contact 55 dans laquelle on peut engager tout contact mâle ou carte. Des nervures 56 peuvent être prévues pour caler en position le câble plat 51, qui peut être fixé par ailleurs au corps 52-54 par tout moyen approprié. La paroi 53, au bord de la fente 55, se termine par un crochet extérieur 56 permettant de caler le bord d'une carte 58. Celle-ci comporte des perforations 59 pour faire passer les bouts 51d de conducteurs, qui peuvent être soudés aux circuits de la carte 58. On choisira de préférence dans ce cas pour le câble 51, un isolant plastique qui résiste à la température du soudage à la vague.La section des conducteurs 51d peut être galbée longitudinalement comme représenté sur la figure 6.

La figure 7 représente schématiquement une limande encartable irréversible 71. Elle est constituée de trois parties : une partie principale 72, non limitée en longueur et pouvant comporter à l'extrémité droite toute formation de contact de raccordement ; une partie 73 de contact présentant des conducteurs non garnis, et une extrémité 74 repliée contre la limande 72 et, de préférence fixée à celle-ci, comprenant l'enrobage pour assurer le maintien des positions relatives des fils. On a réalisé un contact électrique multiple élastique, pratique et bon marché.

La figure 8 représente une limande 81 réversible, comportant essentiellement les trois mêmes parties 82, 83, 84 de celle de la figure 7, mais disposées différemment. La partie 83 des conducteurs non garnis, forme un contact sur chaque face, 83a et 83b, réalisant une limande réversible.

La figure 9a représente un exemple d'application du procédé de l'invention à la fabrication d'un connecteur pour support de composant. Un composant 90 est connecté à un circuit imprimé 91 par l'intermédiaire d'un connecteur 92 comprenant deux éléments identiques 93a, logés dans des alvéoles du connecteur. Chaque élément 93 est constitué de cinq parties : trois parties enrobées séparant deux longueurs de conducteurs non enrobés, et recourbés pour obtenir l'élasticité souhaitée. D'autres variantes d'éléments de contacts 93b, 93c et 93d sont représentées schématiquement sur les figures 9b, 9c, 9d.

Les figures 10 et 11 représentent un autre exemple d'application de l'invention à un connecteur de liaison 95 entre deux circuits imprimés 96, 97. Le connecteur est formé de deux parties enrobées 98, 99, maintenant entre elles un faisceau de contacts 100, dont un sur deux 100a, est galbé vers le haut et l'autre 100b vers le bas, pour conférer au connecteur une épaisseur variable avec des contacts élastiques. Ce motif peut être répété.

Les exemples ci-dessus montrent la variété des connecteurs qui peuvent être réalisés avec le procédé de l'invention. Il suffira, une fois qu'un connecteur aura été conçu et dessiné, de choisir le nombre, la forme et les espacements des conducteurs, et pour les bandes isolantes, la largeur et les découpages appropriés.

La présente invention combine les avantages afférant aux câbles en nappe : pluralité de conducteurs parallèles isolés entre

0195871

eux, et aux contacts électriques préformés et maintenus sur rives porteuses permettant de transférer simultanément un groupe de contacts dans l'isolant.

On confère aux conducteurs du câble en nappe en les dénudant (pratiquement en évitant de les isoler sur certaines zones) en les séparant, en les formant, une rigidité et une élasticité suffisantes pour permettre :

a) une surface de contact ;

b) une force d'appui élastique ;

c) une sécurité de contact ;

d) une indépendance des contacts leur permettant une adaptabilité aux irrégularités géométriques des surfaces de contact avec lesquelles ils coopèrent ;

e) de maintenir en les isolant une cohésion entre les contacts immobilisés à un pas déterminé ; et

f) la manipulation d'un nombre important de contacts en une seule opération ;

ce qui simplifie considérablement le moulage des boitiers recevant les contacts existants. Les détails de moulage compliquent considérablement les moules et requièrent une grande précision. Le fait que les contacts soient liés entre eux par une partie isolante permet de les fixer aisément par des moyens coopérant avec l'ensemble des contacts considéré comme un peigne. On peut avoir une grande précision sur le pas, et donc réaliser des "peignes" dont les contacts sont très rapprochés, ce que l'on ne sait pas faire facilement avec les connecteurs. On peut atteindre sans aucun problème des pas de 1,27 mm par exemple.

Il va de soi que les modes de réalisation décrits ne sont que des exemples et qu'il serait possible de les modifier, notamment par substitution d'équivalents techniques, sans sortir pour cela du cadre de l'invention.

Revendications

1. Procédé de fabrication d'un connecteur électrique multipolaire comportant les étapes suivantes :
- on dispose parallèlement, en une nappe plane, un certain nombre de conducteurs (1) en matériau à mémoire élastique ;
- on applique sur la nappe au moins une feuille de matière isolante (2a, 2b), de façon à maintenir les conducteurs relativement les uns par rapport aux autres ;
- on découpe le connecteur dans la nappe recouverte ; et,
- on effectue des pliages appropriés du connecteur.

2. Procédé selon la revendication 1, dans lequel on applique sur chaque côté de la nappe, une feuille de matière isolante, avantageusement thermosoudable.

3. Procédé selon une des revendications 1 ou 2, dans lequel au moins une des feuilles de matière isolante comporte des ouvertures (3, 4).

4. Procédé selon la revendication 1, caractérisé en ce que l'on enlève une partie de la matière isolante, par découpage ou meulage notamment.

5. Procédé selon une des revendications précédentes, caractérisé en ce que le connecteur est rendu solidaire d'un bloc isolant.

6. Connecteur réalisé selon le procédé des revendications 1 à 5.

0195871

1/3

Fig. 2

Fig. 1

Fig.3

Fig.3A

Fig.4

Fig.5

Fig.6

**Fig.7**

71

72

73    74

**Fig.8**

81    83a

83    82

83b  84

**Fig.9b**

93b

**Fig.9c**

93c

**Fig.9d**

93d

**Fig.9a**

90

92

93a  91

**Fig.11**

100a

96

97

99  100b  98

**Fig.10**

98  100b  100a

95

Office européen
des brevets

**RAPPORT DE RECHERCHE EUROPEENNE**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X,Y | US-A-4 217 155 (AMP)<br>* Colonne 4, ligne 62 - colonne 5, ligne 16; figure 7 * | 1-6 | H 01 R 23/66<br>H 01 R 43/24<br>H 01 B 7/08 |
| Y | DE-A-2 513 635 (W. KELLER)<br>* Page 3, lignes 21-27; figures 2,14 * | 3-6 | |
| X | GB-A- 235 072 (SIEMENS)<br>* Page 2, lignes 27-93; figures 4,5 * | 1-4 | |
| A | CH-A- 512 833 (W. KELLER)<br>* Colonne 2, ligne 23 - colonne 3, ligne 7; figures 7,8 * | 3-6 | |
| A | GB-A-2 134 331 (CAMBION ELECTRONIC)<br>* Page 1, lignes 23-34; figure 3 * | 1 | **DOMAINES TECHNIQUES RECHERCHES (Int. Cl.4)** |
| E | FR-A-2 557 385 (J. NOZICK)<br>* En entier * | 1-6 | H 01 R 23/00<br>H 01 R 43/00<br>H 01 B 7/00<br>H 01 B 17/00 |

Le présent rapport de recherche a été établi pour toutes les revendications

| Lieu de la recherche | Date d'achèvement de la recherche | Examinateur |
|---|---|---|
| LA HAYE | 17-12-1985 | CRIQUI J.J. |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

& : membre de la même famille, document correspondant

OEB Form 1503 03.82